# EUROPEAN PATENT SPECIFICATION

(11) **EP 4 589 276 B1**
(45) Date of publication and mention of the grant of the patent: **18.11.2026**
(21) Application number: 24152186.3
(22) Date of filing: 16.01.2024
(51) Int. Cl.: G01M 5/00, G01H 1/06, G01H 1/08, H02G 1/02, G01R 31/08

(54) **TRAVELLING WAVE BASED METHOD AND DEVICE FOR MONITORING SEVERITY OF VIBRATION IN OVERHEAD POWER LINES**
WANDERWELLENBASIERTES VERFAHREN UND VORRICHTUNG ZUR ÜBERWACHUNG DES SCHWEREGRADES VON SCHWINGUNGEN IN FREILEITUNGEN
PROCÉDÉ ET DISPOSITIF BASÉS SUR DES ONDES PROGRESSIVES POUR SURVEILLER LA GRAVITÉ DE VIBRATIONS DANS DES LIGNES ÉLECTRIQUES AÉRIENNES

(43) Date of publication of application: 23.07.2025
(73) Proprietor: Ampacimon SA, 4431 Loncin (BE)
(72) Inventor: GODARD, Bertrand, 4100 SERAING (BE)
(74) Representative: AWA Benelux

(56) References cited:
- EP-A1- 4 075 109
- US-A1- 2014 136 140

## Description

### Field of the Invention

The present invention relates to electrical power engineering and distribution and more specifically to a method for estimating, measuring or monitoring severity of vibrations of any type, such as, but not limited to, Aeolian vibration, galloping, buffeting, wake induced oscillations, in suspended cable spans of electric power lines such as overhead electrical grid power lines or catenary connection systems in train power lines.

The invention also relates to a device or system for carrying out the above-mentioned method.

### Background and Prior Art

Overhead conductors are frequently subjected to Aeolian vibration, which may lead to the fatigue failure of the conductor. This wind-induced vibrations causes cumulative fatigue damage and fatigue-related failure of strands. It is well known in the overhead lines community that Aeolian vibrations cause fretting fatigue in or around the clamp/conductor system and lead to aging of the conductors.

As detailed in European patent application EP 4 075 109 A1 and according to Guérard S, Power Line Conductors, a Contribution to the Analysis of their Dynamic Behaviour, PhD Thesis, University of Liege (2011), fretting fatigue is an extremely complex problem owing to its synthetic geometry and loading condition and fatigue indicators is a practical image of the fatigue risk on a span for engineers in charge of the maintenance of transmission assets. According to aforementioned references, *"method and device installed in the fields able to estimate the real-time vibration intensity or severity is of prime importance and is a key tool for asset condition management of overhead lines and for operating the lines in a more known environment".*

In case of a unique frequency of oscillation, vibration severity of overhead power lines is defined as the product of frequency f of vibration times the free-loop antinode amplitude A. This fatigue indicator is helpful for determining alternating bending stresses caused by vibration that can lead to fatigue of the conductor. As fretting fatigue is a very complex phenomenon, idealized simplified bending stresses are considered in practice. Those bending stresses are directly related to severity of vibration. Formulas for bending stresses are available in the literature (see for example European patent application EP 4 075 109 A1 or Guérard S, Power Line Conductors, a Contribution to the Analysis of their Dynamic Behaviour, PhD Thesis, University of Liege (2011)).

As detailed in European patent application EP 4 075 109 A1, oscillations number of cycles obtained from frequency of vibration combined to stress levels can be used for fatigue and lifetime estimation.

Currently, on-line monitoring is widely applied to monitor power lines. As explained in U.S. Patent No. 8,184,015 B2, continuous monitoring of electrical power lines, in particular high-voltage overhead lines, is essential to timely detect anomalous conditions which could lead to a power outage. Smart sensors are increasingly equipping power lines. One of their actual main applications is linked with dynamic line rating ("Guide for application of direct real-time monitoring systems", CIGRE Technical brochure No. 498, Study Committee B2, 2012). Dynamic Line Rating (DLR or real time thermal rating RTTR) is nowadays a must for many utilities (A. Deb, "Power line ampacity system", CRC Press, 2000, 251 pages). However, in the past, decisions on the management of overhead transmission lines were frequently based on the qualitative judgment and not directly related to monitoring/measurement devices installed on the fields. Unfortunately, this concern has not been included yet in analysis/measurement directly related to the above-mentioned DLR applications.

Moreover, given the importance of power line monitoring, several devices and systems have been proposed to measure at least some of the relevant parameters related to fatigue indicators. For example, it is known to install displacement measurement systems (such as Pavica, Vibrec, etc.) at a given short distance (e.g. 89mm) from a cable suspension point in order to measure high-frequency vibrations, but this is only a partial solution to the monitoring problem and, in particular when fittings like dampers, warning spheres, armor rods, etc., are installed along the span (the bending amplitude at suspension is not only the one to be considered as highlighted in previous section). These devices are not installed on dead-end spans.

This is only a partial solution to the monitoring problem and such systems are solely oriented to evaluate the lifetime of power line conductor due to the bending fatigue induced by Aeolian vibrations cycles on conductor strands near clamps.

As a second example, fibre optic sensor technologies are finding growing application in the area of monitoring civil structures. The most attractive fibre optic sensor is the Fibre Bragg Grating (FBG) which is sensitive to strain in any form, that is from bending, stretching or temperature change. It is detailed in L. BJERKAN et al, Measurements on an Aeolian vibrations on a 3 Km fjord crossing with fiber-optic bragg grating sensors, CIGRE 2004, B2-314 and Leif Bjerkan, Application of fiber optic Bragg grating sensors, monitoring environmental loads of overhead power transmission lines, Applied Optics Vol. 39, No. 4, 554-560, Feb. 2000, that, such as FBG measurement, is able to estimate vibration of overhead lines. The existing drawback of this method is that most of the time fibre optic is not available in existing overhead conductor and its installation is difficult, the fiber optic cable must be retrofitted to one strand of the conductor or wrapped along the whole span with specific machine and caution should be addressed in case of existing fittings on the line. The instrumentation must be directly connected to a computer, at the end of the section for example, for data acquisition and analysis.

In another example, sag of power lines monitoring can be performed by measuring vibrations of the conductor as detailed in U.S. Patent No. 8,184,015 B2. As detailed in the above-mentioned patent, sag is solely determined by the fundamental frequency estimation of the vibrations of the conductor. Previously sag monitoring system was directly related to dynamic line rating of power lines and this has no direct relationship with vibrations severity measurement and/or estimating free-antinode amplitude from local vibrations measurement. A drawback of this method in estimating the free antinode amplitude and severity of vibration is that the conversion of local vibrations measurement to free antinode amplitude needs a known mode shape for each excited frequency. Sometimes it is very difficult to get mode shape, especially when dampers are considered as their frequency impedance depends on velocity at dampers location, not known from the fields as no measurement is available, and/or impedance curves are not known or partially known at specific velocity value. In addition, results from predetermined models are prone to error for complex vibration phenomena such as vortex-induced vibration, as needed parameters are unknown and/or inaccurate. Therefore, such a method is prohibitive and likely to be inaccurate when applied to real installation. Therefore, a device directly installed on the line monitoring directly giving antinode amplitude with no need-to-know mode shape would be helpful.

In another example, US 2014/0163884 A1 a determination of parameters related to the speed of wind that blows near an overhead electrical power line (with single or bundle conductors) is disclosed. The wind speed value is estimated through vibrations measurement of the conductor. Previously monitoring system was directly related to dynamic line rating of power lines, and this had no direct relationship with vibrations severity measurement and/or estimating free antinode amplitude from local vibrations measurements.

In another example, U.S. Patent No. 5,235,861 A and U.S. Patent No. 5,517,864 A detail a power line monitoring using tension sensor measurement located at a line pole. A drawback of this method is that the conductor must be disconnected from the pole when the measurement device is installed at the pole. U.S. Patent No. 6,343,515 B1 details a method and apparatus to perform a measure of tension in any location along a wire. Other older patents, as for example U.S. Patent No. 7,424,832 B1, use the same methodology to measure the tension in a wire. Patent application EP 3 249 766 A1 presents a local tension measurement combined to sag measurement to estimate atmospheric accretion on suspended cable of a power lines.

The devices and methods of previously cited patents are related to power line monitoring, but this has no direct relationship with vibrations severity measurement and/or estimating free-antinode amplitude from local vibrations measurements.

U.S. Patent No. 8,725,429 B2 is directly related to fatigue monitoring of a cable. The drawback of this method is that the measurement of bending force for an overhead line is very difficult as the measurement device must face electrical constraint due to voltage during operation. This is not considered in the above-mentioned patent, and this has no direct relationship with estimating free-antinode amplitude from local vibrations measurements. Thus, this method is not directly usable in the field of power lines since no attention is paid to high voltage constraints, as for example a need for electromagnetic shielding of the monitoring electronics, for anti-corona design, etc. This method is related to limited to in-situ monitoring capabilities, power supply and data communication, or other alike. In the above-mentioned patent it is also noted that some existing patent (U.S. Pat. No. 7,080,689 B2) discloses a complex system, not directly related to overhead lines, that relies on the presence of multiple sensors along the length of a drilling riser and unfortunately requires many additional sources of data, such as environmental data. A direct device and method estimating fatigue indicators may fix these drawbacks.

European patent application EP 4,075,109 A1 is directly related to fatigue monitoring of a cable. The estimation of severity of vibrations is obtained from dynamic tension measurement. Tension is obtained by measuring the restoring force using strain measurement when deflection is imposed to the cable. It is well-known from literature (see for example H. Irvine, Cable Structures. MIT Press, Cambridge, 1981) that to first order, no additional (dynamic) cable tension is induced by the motion of antisymmetric in-plane modes (additional cable tension is induced by the motion for symmetric in-plane modes). Then, the free-loop antinode amplitude of those modes cannot be estimated from dynamic tension measurements. The present invention aims at fixing the corresponding issue among others.

Currently, on-line monitoring vibrations is widely applied to monitor power lines. Aforementioned examples are mainly related to accelerometer-based ways for monitoring vibrations of power lines. Inertial measurement unit *(IMU)* sensors that are based on multi-axis combinations of gyroscopes, accelerometers, magnetometers... are widely available on the market nowadays and are attracting more and more attention and provide small and affordable sensors that can measure physical quantities like acceleration, angular velocity, and magnetic fields, allowing those inertial sensors to be widely and more and more used in motion analysis and tracking applications. Thus, those Inertial measurement units are applied to monitor vibrations and in particular vibrations of power lines.

As an example, The Electric Power Research Institute (EPRI) has developed and made available the Overhead Conductor RF Monitors sensors to address a range of applications including ratings, Aeolian vibration, conductor galloping and blowout (see for example https://rfmonitors.epri.com/monitors/overhead-conductor-monitor/, accessed July 2023). The robust, low-cost RF Monitors measure a range of parameters which are used by integrated algorithms to calculate conductor motion and rating metrics. From aforementioned reference, one cannot know either how sensor readings are converted to free-loop antinode amplitude or severity of vibrations or how sensor readings are analysed for reconstructing amplitude motion. The shared information is limited to the following: *"Algorithms integrated into the sensor use the accelerations and rotational velocities to calculate conductor motion metrics including displacement and dominant frequencies".* As IMU give access to oscillations and movements in integrated board nowadays, it is obvious that the sensing device readings can theoretically be used to calculate / estimate motion metrics.

It can be found in the literature that IMU are used for monitoring motion of power lines, especially gallop. As an example, and as detailed in K. Xie et al., Tracking Galloping Profile Transmission Lines using Wireless Inertial Measurement Units, Journal of Computer and communication, 2015, 3, 220-228, IMU readings are processed using a descent fusion algorithms and coordinate transformation to estimate orientation and position over time. Motion is reconstructed at sensor location and not along the transmission lines which is not enough for estimating free-loop antinode amplitude and consequently severity of vibration. Moreover, the method used in aforementioned reference is not using the travelling wave method. As a second example related to galloping, X. Huang et al., Design of a wireless sensor Module for monitoring conductor Galloping of Transmission Lines, Sensors 2016, 16, 1657, IMU can be used to monitor gallop to avoid errors caused by twist due to torsion of conductor during gallop. There are in the aforementioned reference no details on how motion can be or is reconstructed along the suspended conductor. On aforementioned reference, reconstructed motion is shown at one sensor location and motion along suspended conductor is assumed to be used using multiple sensors and curve fitting method in further. Using multiple sensors may add difficulties like time synchronization of all sensor readings. It is also explained in aforementioned reference that a cut-off frequency of 5 [Hz] is used for monitor of gallop. This limited frequency is valid for galloping events, as gallop is a low frequency high amplitude motion, but this situation is not valid for monitoring Aeolian vibration of power lines because typical frequency range of Aeolian vibration is of about [5-150] [Hz].

Traditionally, dynamic behaviour of structures is analysed using modal approach and decomposition and separation of time and space variables. Motion is decomposed in time-dependent only functions and space-dependent only functions, i.e. the normal mode of vibrations. Then, vibration amplitudes are represented as a sum of standing waves in space. The dynamic behaviour of a structure can be formulated in terms of the waves propagating through its members parts. This approach is commonly known as the Travelling Wave Method (TWM). A standing wave is a result of two travelling waves traveling in opposite directions. The Travelling Wave Method can be used for estimating metrics related to free-loop antinode amplitude of a suspended cable. From C.B. Rawlins, an efficient method for measuring dissipation by dampers in laboratory spans, IEEE Transactions on Power Delivery, Vol. 3, No. 3, July 1988, travelling waves functions that define the amplitude along suspended cable can be obtained from motion amplitude measurement at one location combined to time integration of space-derivative of the motion. As detailed in aforementioned reference, space-derivative is obtained through difference of amplitude measurements signals at two different locations a short distance apart and dividing those signals by the separation distance, leading to errors that become greater as wavelengths of motion become shorter. Moreover, amplitude measurements signals are mainly sensed by displacement sensing devices. Amplitude of motion and space-derivative is not sensed using modern available sensing devices like accelerometer and IMU.

From H. Marcollo et al., Traveling wave response in full-scale drilling riser VIV measurement, Proceedings of the 30th International conference on ocean, offshore and arctic engineering, OMAE 2011, June 19-24, 2011, Rotterdam, Netherlands, it can be found that travelling wave method is studied for drilling riser. From aforementioned reference, the travelling wave method is handled using multiple sensors wherein the time synchronization cannot be guaranteed. The main concern of the aforementioned reference is to characterize traveling waves or standing waves using multiple sensors installed along the drilling riser. Thus, the aforementioned reference is neither directly considering reconstruction of motion along the riser or an estimation thereof, nor estimating the free-loop-anti node amplitude, nor the severity of vibration. Aforementioned reference gives bending stress in function of the travelling waves and time history of the acceleration. It is clearly indicated in the aforementioned reference that fatigue estimates are based on measured values at sensor locations and do not require assumptions on the full length of the riser. This is part of the method to be applied for monitoring severity of vibration in practice as free-loop antinode may occur at location different from the locations of the sensors.

### Aims of the Invention

Aeolian vibrations of overhead lines have been known for years. Left uncontrolled, these vibrations, which are excited by the oscillatory forces caused by Von Karman vortices, lead to fatigue damage of the conductors. Hence there is a need for a suitable system for real-time and on-site monitoring the severity of vibrations and a need for suitable updated calculation for predicting the vibrations level thanks to adequate fields measurements.

The present invention thus aims at providing on-line direct local measurement and monitoring of vibrations' severity in overhead power lines for a number of applications.

The invention aims in particular at providing a method for monitoring the transmission and distribution network since wind-induced mechanical-dynamical phenomena experienced on overhead lines can lead to mechanical damages of the conductors as a result of material fatigue, mechanical damages of the insulators, armatures and towers and therefore power outages or failure.

### Summary of the Invention

A first aspect of the present invention relates to a method for estimating the severity of vibration, which is the product of vibration frequency f by antinode amplitude of vibration *A,* and for estimating fatigue lifetime or damage of a suspended electrical cable span of overhead power lines, said suspended electrical cable span having a sag possibly negligible with respect to span length, and a mean local tension *H,* and a local oscillating motion amplitude *u(x, t)* with a local space derivative of motion $\frac{\partial u}{\partial x}$, and being subject to a variation of said tension *H,* motion amplitude *u(x, t)* and said space derivative over time $\frac{\partial u}{\partial x}$*,* due to vibration, said method using an autonomous device respectively comprising a tension measuring device, a motion amplitude measuring device and a space derivative measuring device mounted thereon and fixed to the suspended cable span, as well as an on-board or remotely connected data processing unit, said method comprising the steps of :
a. measuring the mean local tension H of the suspended span over a time range, with the tension measuring device, so as to obtain a time-dependent tension measurement signal,
b. measuring the local motion amplitude *u(x, t)* and the local space derivative of motion amplitude $\frac{\partial u}{\partial x}$ of the suspended span over a time range, with the motion amplitude and the space derivative measuring devices respectively, so as to obtain a time-dependent motion measurement signal, said antinode amplitude of vibration *A* being related to the respective measurements of local motion and space derivative thereof ;
c. performing a frequency or time-frequency analysis of said time-dependent tension measurement signal, with the data processing unit ;
d. performing a frequency or time-frequency analysis of said time-dependent motion amplitude measurement signal, with the data processing unit ;
e. performing a frequency or time-frequency analysis of said time-dependent space derivative of the motion amplitude measurement signal, with the data processing unit ;

wherein said estimation of the severity of vibration *Af* is obtained from the measurements of said amplitude motion *u(x, t)* and said space derivative of the motion amplitude $\frac{\partial u}{\partial x}$ according to the formula : $\sqrt{{c}^{2} {\left(\frac{\partial u}{\partial x}\right)}^{2} + \frac{1}{{ω}^{2}} {\left(\frac{{\partial }^{2} u}{\partial {t}^{2}}\right)}^{2}} = 2 π \left(Af\right) {e}^{jωt}$
where *ω,* $c = \sqrt{\frac{H}{m}}$, *H, m,* $\frac{\partial u}{\partial x}$*,* and $\frac{{\partial }^{2} u}{\partial {t}^{2}}$, are respectively the pulsation of the oscillating motion, the wave speed, the mean local tension of the suspended cable span, the mass per unit length of the suspended cable span, the space derivative of said motion amplitude, and the acceleration of said motion amplitude ;
and wherein said fatigue lifetime or damage are obtained from a number of cycles estimated from said tension frequency analysis and a stress level is obtained from said motion amplitude and said space derivative of the motion amplitude.

According to preferred embodiments, the method is further limited by at least one of the following characteristics or by a suitable combination thereof :
- said motion amplitude measuring device and said space derivative measuring device measuring device are operating within a passband extending between 0 Hz and 1000 Hz ;
- said wave speed $c = \sqrt{\frac{H}{m}}$, is obtained from mean local tension *H* itself estimated from sag / frequency analysis, or by the relation between sag and tension being approximately given by sag = mgL²/8H, where m is the mass per unit length, g is the gravity constant, and L the span length ;
   said sag being obtained from frequency analysis of conductor span motion or by local measurement of sagging curve inclination being directly related to sag in a relation between tilt of sagging curve and sag, approximately being a linear function in case of valid parabola approximate or by a more complex function in the general case ;
- the local tension is measured by imposing a deflection to the cable portion of the overhead power line going through the autonomous device, using a device like a load cell, and measuring restoring force or strain, or is estimated by vibration frequency analysis of conductor motion, tilt measurement or accurate spatial localization of one or multiple point along the sagging curve, using accelerometers or an IMU ;
- the estimation of the severity of vibration, defined as the product of said antinode amplitude by said frequency, is obtained from the combined measurements of the local motion acceleration $a = \frac{{\partial }^{2} u}{\partial {t}^{2}}$ using an accelerometer and the time integration of the time derivative of angle, $\frac{\partial u}{\partial x} = \int {\partial }_{t} \left(\frac{\partial u}{\partial x}\right) dt = \int {gy}_{x} dt$ using an IMU gyroscope according to the following formula : $\sqrt{{c}^{2} {\left[\int {gy}_{x} dt\right]}^{2} + \frac{1}{{ω}^{2}} {a}^{2}} = 2 π \left(Af\right) {e}^{jωt}$
- the free-loop antinode amplitude A is obtained as the maximum of a reconstructed amplitude along said suspended span using time-dependent signals of motion amplitude and time integration of said space derivative of motion shape along the vibrating conductor, using the following equation for the spatial distribution of the wave : $u \left(x=x0+j\frac{c}{fe}, t=\frac{n}{fe}\left[s\right]\right) = {f}_{1 , x 0} \left(n+j\right) + {f}_{2 , x 0} \left(n-j\right)$ where *f*_{1*,x*0} and *f*_{2,*x*0} are respectively two travelling waves *f*₁, *f*₂ measured at location *x*₀*, fe* [Hz] is the sampling frequency of data and *n* the time index component of time-dependent signal value, index *j* [-] represents the time laps corresponding at a change of location along the string, with the following limit conditions ${x}_{0} - {j}_{min} \frac{c}{fe} = 0$ and ${x}_{0} + {j}_{max} \frac{c}{fe} = l ,$*,* the spatial resolution *dx* of the reconstruction of motion being depending on sampling frequency and wave speed and given by $dx = \frac{c}{fe}$*.*

Another aspect of the invention relates to a non-transitory computer-readable medium with instructions stored thereon, that when executed by a computer processor, performs the steps of the aforementioned method, when the computer processor is on-board in the autonomous device or remotely connected to the autonomous device comprising the tension measuring device, the motion amplitude measuring device and the motion amplitude space derivative measuring device mounted thereon for respectively measuring the local tension, the local acceleration and the local motion space derivative of the suspended span over a time range.

Still another aspect of the invention relates to a monitoring system for estimating the severity of vibration, which is the product of vibration frequency f by antinode amplitude of vibration A, and for estimating fatigue lifetime or damage of a suspended electrical cable span of overhead power lines, said system comprising :
- an autonomous device fixed on said suspended cable span, and comprising respective tension, motion amplitude and motion amplitude space derivative measuring devices mounted thereon ; and
- an on-board data processing unit or a data processing unit remotely connected to the autonomous device ;
   and configured to implement at least part of the following steps :
   - measuring the mean local tension H of the suspended span over a time range, with the tension measuring device, so as to obtain a time-dependent tension measurement signal, said antinode amplitude of vibration *A* being related to the mean local tension measurement ;
   - measuring the time-dependent local motion amplitude *u*(*x, t*) and local space derivative of motion amplitude $\frac{\partial u}{\partial x}$ of the suspended span over a time range, with the motion amplitude and the space derivative measuring devices respectively, so as to obtain a time-dependent motion measurement signal, said antinode amplitude of vibration *A* being related to the respective measurements of local motion and space derivative thereof ;
   - performing a frequency or time-frequency analysis of said time-dependent tension measurement signal, with the data processing unit ;
   - performing a frequency or time-frequency analysis of said time-dependent amplitude measurement signal or said motion space derivative measurement signal, with the data processing unit;

wherein said estimation of the severity of vibration *Af* is obtained from the measurements of said amplitude motion *u(x, t)* and said space derivative of the motion amplitude $\frac{\partial u}{\partial x}$ according to the formula : $\sqrt{{c}^{2} {\left(\frac{\partial u}{\partial x}\right)}^{2} + \frac{1}{{ω}^{2}} {\left(\frac{{\partial }^{2} u}{\partial {t}^{2}}\right)}^{2}} = 2 π \left(Af\right) {e}^{jωt}$
where *ω,* $c = \sqrt{\frac{H}{m}}$, *H, m,* $\frac{\partial u}{\partial x}$*,* and $\frac{{\partial }^{2} u}{\partial {t}^{2}}$, are respectively the pulsation of the oscillating motion, the wave speed, the mean local tension of the suspended cable span, the mass per unit length of the suspended cable span, the space derivative of said motion amplitude, and the acceleration of said motion amplitude ;
and wherein said fatigue lifetime or damage are obtained from a number of cycles estimated from said tension frequency analysis and a stress level is obtained from said motion amplitude and said space derivative of the motion amplitude.

Advantageously, the motion amplitude or acceleration measuring device consists in one or more accelerometers and the motion amplitude space derivative device consists in one or more gyroscopes.

Still advantageously, motion amplitude or acceleration measuring device and the motion amplitude space derivative device consists in an IMU or a combination of accelerometers and gyroscopes.

### Brief Description of the Drawings

Fig. 1 is representing two oppositely moving travelling waves of arbitrary shape.
Fig. 2 is illustrating a travelling wave and a standing wave at different successives times. (A) is illustrating the travelling wave and (B) is illustrating the standing wave.

### Description of Preferred Embodiments of the Invention

While the invention is amenable to various modifications and alternative forms, specifics thereof have been shown by way of example in the drawings and will be described in detail. It should be understood, however, that the intention is no to limit aspects of the invention to the particular embodiments described. On the contrary, the intention is to cover all modifications, equivalents, and alternatives falling within the scope of the claims.

For the following defined terms, these definitions shall be applied, unless a different definition is given in the claims or elsewhere in this specification.

All numeric values are herein assumed to be preceded by the term "about", whether or not explicitly indicated. The term "about" generally refers to a range of numbers that one of skill in the art would consider equivalent to the recited value (i.e. having the same function or result). In many instances, the term "about" may be indicative as including numbers that are rounded to the nearest significant figure.

Any recitation of numerical ranges by endpoints includes all numbers within that range (e.g., 1 to 5 includes a.o. 1, 4/3, 1.5, 2, e, 2.75, 3, π, 3.80, 4, and 5).

Although some suitable dimension ranges and/or values pertaining to various components, features and/or specifications are disclosed, one of skill in the art, incited by the present disclosure, would understand desired dimensions, ranges and/or values may deviate from those expressly disclosed.

As used in this specification and the appended claims, the singular forms "a", "an", and "the" include plural referents unless the content clearly dictates otherwise. As used in this specification and the appended claims, the term "or" is generally employed in its sense including "and/or" unless the content clearly dictates otherwise.

The following detailed description should be read with reference to the drawings in which similar elements in different drawings are numbered the same. The detailed description and the drawings, which are not necessarily to scale, depict illustrative embodiments and are not intended to limit the scope of the invention. The illustrative embodiments depicted are intended only as exemplary. Selected features of any illustrative embodiment may be incorporated into an additional embodiment unless clearly stated to the contrary.

The present disclosure relates to a method and a device for measuring/monitoring severity of vibrations of all possible types, e.g. Aeolian vibrations , buffeting, wind-induced, subspan, etc., with respect to a suspended span of cable or for an electric power line comprising such a suspended cable span.

The invention may nevertheless have other applications in fields not directly related to electric power transmission.

In case of a multiple-span section, a monitoring device according to the present invention has to be repeated on all critical spans or on spans intended to be specifically monitored along the section.

In a purpose of analysis and explanation, the computation and formulas are simplified by assuming a levelled span with fixed supports having relative small and negligible sag compared to span length - in practice sag is most of the time of about from 2% to 4% of span length, uniform loading, i.e. uniform conductor weight per unit length, ice and wind pressure neglected here, along a suspended cable, bending stiffness effect neglected, and no out-of-plane vibration (during Aeolian vibration, vibrations are perpendicular to wind speed, i.e. are mainly vertical in case of overhead lines), and any other well-known hypotheses being easily obtained from aforementioned references. Further there are no fittings on the conductor, Irvine's parameter effect is negligible, there is no damping, no bending stiffness, no effect of insulations chains, etc.

In that simplified case, the suspended cable can be considered as a vibrating string (or span) and differential equation governing the displacement along the string is given by the well-known wave equation : ${c}^{2} \frac{{\partial }^{2} u}{\partial {x}^{2}} = \frac{{\partial }^{2} u}{\partial {t}^{2}}$ where :
*u* = *u*(*x, t*) [m] is amplitude of motion over time along the span,
*t* [s] is time,
*x* [m] is position along the span,
$c = \sqrt{\frac{T}{m}} \left[m/s\right]$ is velocity of travelling waves,
*T* [N] is tension,
*m* [kg/m] is mass per unit length of the conductor,
*∂* [-] is the symbol for partial derivative,
$\frac{{\partial }^{2}}{\partial {x}^{2}}$ is the second spatial derivative of the displacement *u*(*x, t*), and
$\frac{{\partial }^{2}}{\partial {t}^{2}}$ is the second time derivative of the displacement *u*(*x, t*),

Vibration amplitudes *u*(*x, t*) are often represented as a sum of standing waves in space through modal approach (separation of time and space variables, i.e. setting *u*(*x, t*) *= φ*(*x*)*U*(*t*) where *φ*(*x*) is mode shape that depends on position x only and *U*(*t*) is a time-dependent only function. The standing waves in space are the normal modes *φ*(*x*) of vibration from the modal decomposition. It is well-known that normal mode shapes of the aforementioned wave-equation is then given by : $φ \left(x\right) = Asin \left(\frac{ω}{c}x\right)$ where *ω* = 2*πf* [s] is the pulsation of the motion and A [m] is the free-loop antinode amplitude of motion. Those pulsations are given with an end condition at *x = l,* where l [m] is length of string, i.e. $\frac{{ω}_{k} l}{c} = kπ$*, k* = 1,2,3, *etc.* This leads to the well-known frequency of vibrations of a vibrating string ${f}_{k} = \frac{k}{2 l} c = \frac{k}{2 l} \sqrt{\frac{T}{m}}$.

Given a motion amplitude measurement *φₘₑₐₛ = φ*(*xₘₑₐₛ*) at a given location *xₘₑₐₛ,* free-loop antinode amplitude *A* can be easily obtained from given well-known mode shape as $A = {φ}_{meas} / sin \left(\frac{ω}{c}{x}_{meas}\right)$. This of course is not valid for measurement located at a node where there is no measured motion. This could be overcome using multiple motion sensing sensors and least mean square fitting method using the multiples measurements and locations. Using multiple sensors adds complexity in data acquisition and processing (synchronization for example, needs for knowing the exact locations of the sensors).

The dynamic behaviour of a structure can be formulated in terms of the waves propagating through it. This approach is commonly known as the Travelling Wave Method (TWM). The TWM is a wave propagation approach, in which the dynamic response of a structure is defined by the properties of waves travelling in the elements, and the reflections and transmissions at element discontinuities or limits of the structure.

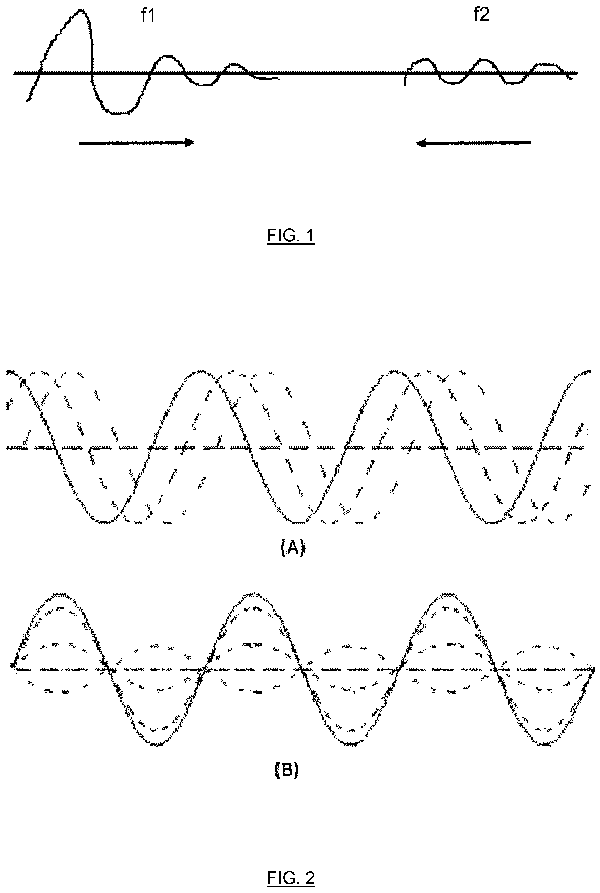

The aforementioned well-known wave equation can be solved using the travelling-waved following form: $u \left(x, t\right) = {f}_{1} \left(t-x/c\right) + {f}_{2} \left(t+x/c\right)$ where *f*₁ and *f*₂ are arbitrary functions describing the profiles of waves moving in the positive and negative directions along x axis aligned with string as illustrated in FIG. 1. Travelling waves move from one place to another, and transport energy, and may happen at any frequency. Two waves moving in the same direction produces a travelling wave. Standing waves do not transmit energy from one place to another, and only occur in certain frequency in confined spaces. Standing waves can be obtained from two travelling waves moving in opposite directions, each having the same amplitude and frequency. Then, their energies are either added together (antinode and locations of high amplitude) or cancelled out (nodes and locations of small amplitude). As the wave travels, maximum motion amplitude (acceleration/displacement) shall occur at every location along the conductor length. This effect is illustrated in FIG. 2.

From C.B. Rawlins, An efficient method for measuring dissipation by dampers in laboratory spans, IEEE Transactions on Power Delivery, Vol. 3, No. 3, July 1988, it can be proven that arbitrary wave functions *f*₁ and *f*₂ may be solved simultaneously from amplitude motion signal available at location *x* and time integral *Iₛ* of the space derivative $\frac{\partial }{\partial x} u \left(x, t\right)$ to obtain : ${f}_{1} \left(t-x/c\right) = \left(u-c∗{I}_{s}\right) / 2$ ${f}_{2} \left(t+x/c\right) = \left(u+c∗{I}_{s}\right) / 2$ where *t* [s] is said time, *x* [m] is said position along the string, *c* [m/s] is said travelling wave speed, *u* = *u*(*x, t*) [m] is said time and space dependent amplitude motion at location *x,* and *Iₛ* is time integration of said space derivative of motion shape along the vibrating conductor, given by ${I}_{s} = \int \frac{\partial u}{\partial x} dt$ Thus, signals amplitude representing the travelling waves can be obtained by combining amplitude measurement at location x and time integral of the space-derivative of the conductor measurement. This procedure is independent of the location x along the span and the respective amplitudes and shapes of *f*₁ and *f*₂.

As explained, the travelling waves can be obtained by combining amplitude measurement at location x and time integral of the space-derivative of the conductor measurement. This is a direct consequence of the travelling wave equation properties. It is well-known in the literature that aforementioned wave equation can be solved by the method of characteristics (see for example Joseph M. Mahaffy, Math 531 - Partial Differential Equations Method of Characteristics for PDEs, Department of Mathematics and Statistics Dynamical Systems Group Computational Sciences Research Center San Diego State University San Diego, CA 92182-7720, Spring 2020).

As explained and well-known in the literature, the method of characteristics applied to aforementioned wave equation that travelling waves propagate (along characteristics) invariant values like combination of time-derivative of motion and space-derivative of motions times wave speed. This can be physically explained for stationary waves at particular locations along string without equations. At antinode, amplitude is continuously varying and space-derivative of motion slope is constant and equal to zero. At node, amplitude is constant and equal to zero and space-derivative (slope) is continuously varying over time. At other locations, a combination of aforementioned values exist. Mathematical proof and detailed equations of invariant propagated along characteristics is well-known in literature. Travelling waves propagate a combination of time-derivative and spatial derivative times the wave speed along characteristics.

Thanks to wave propagation (without modification like the ones that the travelling wave can meet at obstacles that induce transmission and reflections of wave, or with no energy input, ...), a time variation is equivalent to a spatial variation divided by wave speed (according to conservation of energy, see aforementioned invariant along characteristics' curves), one may write : $u \left(x, t\right) = {f}_{1 , x 0} \left(t-\left(x-{x}_{0}\right)/c\right) + {f}_{2 , x 0} \left(t+\left(x-{x}_{0}\right)/c\right)$ where *f*_{1*,x*0} and *f*_{2,*x*0} are respectively the two travelling waves *f*₁, *f*₂ measured at location *x*₀. At that location *x*₀*,* one has, noting *fe* [Hz] the sampling frequency of data and n the time index component of time-dependent signal value, $u \left(x=x0,x0,\frac{n}{fe}\left[s\right]\right) = {f}_{1 , x 0} \left(n\right) + {f}_{2 , x 0} \left(n\right)$ Finally, one may obtain the time evolution of the spatial distribution of the wave by the following: $u \left(x=x0+j\frac{c}{fe}, t=\frac{n}{fe}\left[s\right]\right) = {f}_{1 , x 0} \left(n+j\right) + {f}_{2 , x 0} \left(n-j\right)$ where index *j* [-] represents the time laps corresponding at a change of location along the string. As a time variation is equivalent to a spatial variation divided by wave speed (conservation of energy), enough data samples are needed to reconstruct the spatial distribution along the whole vibrating string, i.e. change of location from *x*0 must reach ends at *x =* 0 and *x = l* where l[m] is said string length. This gives the following conditions ${x}_{0} - {j}_{min} \frac{c}{fe} = 0$ and ${x}_{0} + {j}_{max} \frac{c}{fe} = l$. This spatial resolution *dx* of this reconstruction of motion is depending on sampling frequency and wave speed and given by $dx = \frac{c}{fe}$*.*

Then, combining past and future values of time-dependent signal of amplitude and time-dependent signal spatial derivative, distribution of amplitude of motion can be reconstructed along the suspended span. Free-loop antinode amplitude is then obtained as the maximum amplitude value of this reconstructed distribution.

There is also another way to look at combination of time evolution of space derivative, amplitude of motion and assumed mode shape. Mode shapes of said wave equation is given by $u \left(x, t\right) = Asin \left(\frac{ω}{c}x\right) {e}^{jωt}$ where *ω* [Hz] is the pulsation of the mode. The following mathematical operations give interesting relation: $u \left(x\right) = A sin \left(\frac{ω}{c}x\right) {e}^{jωt}$ $\frac{\partial u}{\partial x} = A \frac{ω}{c} cos \left(\frac{ω}{c}x\right) {e}^{jωt}$ $\frac{{\partial }^{2} u}{\partial {t}^{2}} = - {Aω}^{2} sin \left(\frac{ω}{c}x\right) {e}^{jωt}$ $\begin{matrix}\frac{{c}^{2}}{{ω}^{2}} {\left(\frac{\partial u}{\partial x}\right)}^{2} + \frac{1}{{ω}^{4}} {\left(\frac{{\partial }^{2} u}{\partial {t}^{2}}\right)}^{2} \\ = \frac{{c}^{2}}{{ω}^{2}} {A}^{2} \frac{{ω}^{2}}{{c}^{2}} {\left[cos\left(\frac{ω}{c}x\right)\right]}^{2} {e}^{2 jωt} + \frac{1}{{ω}^{4}} {A}^{2} {\left[-{ω}^{2}\right]}^{2} {\left[sin\left(\frac{ω}{c}x\right)\right]}^{2} {e}^{2 jωt} \\ \frac{{c}^{2}}{{ω}^{2}} {\left(\frac{\partial u}{\partial x}\right)}^{2} + \frac{1}{{ω}^{4}} {\left(\frac{{\partial }^{2} u}{\partial {t}^{2}}\right)}^{2} = {A}^{2} {\left[cos\left(\frac{ω}{c}x\right)\right]}^{2} {e}^{2 jωt} + {A}^{2} {\left[Asin\left(\frac{ω}{c}x\right)\right]}^{2} {e}^{2 jωt} \\ \frac{{c}^{2}}{{ω}^{2}} {\left(\frac{\partial u}{\partial x}\right)}^{2} + \frac{1}{{ω}^{4}} {\left(\frac{{\partial }^{2} u}{\partial {t}^{2}}\right)}^{2} = {A}^{2} {e}^{2 jωt}\end{matrix}$ $\frac{1}{{ω}^{2}} \left[{c}^{2}{\left(\frac{\partial u}{\partial x}\right)}^{2}+\frac{1}{{ω}^{2}} {\left(\frac{{\partial }^{2} u}{\partial {t}^{2}}\right)}^{2}\right] = {A}^{2} {e}^{2 jωt}$ $\left[{c}^{2}{\left(\frac{\partial u}{\partial x}\right)}^{2}+\frac{1}{{ω}^{2}} {\left(\frac{{\partial }^{2} u}{\partial {t}^{2}}\right)}^{2}\right] = {\left(Aω\right)}^{2} {e}^{2 jωt}$ Finally, one obtains : $\frac{1}{ω} \sqrt{{c}^{2} {\left(\frac{\partial u}{\partial x}\right)}^{2} + \frac{1}{{ω}^{2}} {\left(\frac{{\partial }^{2} u}{\partial {t}^{2}}\right)}^{2}} = {Ae}^{jωt}$ One may note $\frac{{\partial }^{2} u}{\partial {t}^{2}}$ is the acceleration *a,* available from accelerometer and a IMU gyroscope gives access to time derivative of angle, i.e ${gy}_{x} = {\partial }_{t} \left(\frac{\partial u}{\partial x}\right)$ and then $\frac{\partial u}{\partial x} = \int {\partial }_{t} \left(\frac{\partial u}{\partial x}\right) dt = \int {gy}_{x} dt$ So, combining accelerometer and gyroscope from imu for example may give access to free-loop antinode amplitude as $\frac{1}{ω} \sqrt{{c}^{2} {\left[\int {gy}_{x} dt\right]}^{2} + \frac{1}{{ω}^{2}} {a}^{2} =} {Ae}^{jωt}$ This combination of readings gives also direct access to severity of vibration defined as the product of frequency *f* times free-loop antinode amplitude *A.* Aforementioned equations is easily transformed to the following. As pulsation is *ω* = *2πf,* one has : $\sqrt{{c}^{2} {\left[\int {gy}_{x} dt\right]}^{2} + \frac{1}{{ω}^{2}} {a}^{2}} = 2 π \left(Af\right) {e}^{jωt}$

Frequency analysis of the time-dependent combination thus gives direct access to severity of vibration *Af.*

It is noted here that there is no dynamic amplitude *u*(*x, t*) = 0 and no dynamic space derivative $- \frac{\partial u \left(x, t\right)}{\partial x} = 0$ because *u*(*x, t*) = 0 for all x if there is no vibration (*A* = 0, *u* = 0, $\frac{\partial u}{\partial x} = 0$ for all *x* as u = 0). It is also noted here that the travelling wave method considers any mode shape as no assumption on mode shape is considered. In the above, the influence of any fitting as dampers, warning sphere, etc. installed along the suspended cable, influence of bending stiffness of suspended cable, and any other parameter influencing mode shape are neglected for a purpose of analysis and explanation. In other words, there is no wave change along the string - there is no reflection/transmission/phase shift of any type because there is no local mechanical impedance change. This should not be seen as a limitation of the previously detailed method, but it is rather used to help the reader to get an understanding of the concern. It is also noted that any particular boundary conditions as movements of attachment ends is included in the travelling waves method.

This means that under assumption that travelling waves are not deformed by obstacles, the inventors have discovered that antinode amplitude is easily accessible from gyroscope and accelerometer readings, knowing wave speed. In particular the time integration of the spatial derivative is given by gyroscope readings.

It is also noted that the aforementioned combination does not depend on sensor location. Then, there is no need to know the location of the sensor(s) and/or the sensor(s) combining those readings can be installed anywhere along the suspended cable.

It is to be noted that the frequency bandpass for cable span motion (amplitude and space derivative) measuring device should be chosen between 0 Hz and 1000 Hz. Wave speed c [m/s] along overhead lines is about 100-150 [m/s]. Noting fe [Hz] the sampling frequency, spatial accuracy is dx=c/fe of about (100-150) / 300 ~ [ 0.3 - 0.5] [m]

Wavelength lambda [m] of vibration is given by lambda = 2*length/k or lambda = c/frequency (extreme cases). Aeolian vibration being up to 150 [Hz] and with c of about 100 [m/s], this gives lambda = 100/150 = 0.66 [m]. Thus, taking spatial resolution dx with fe = 1000 [Hz], dx = c/fe =(100-150)/1000 ~ [0.1-0.15] [m] is acceptable.

It is well known from literature (see for example Kiessling et al, Overhead Power Lines, Planning, Design, Construction, Springer, 2003 ; see for example Cigre Group Task Force B2.12.3, brochure 324, Sag-Tension calculation methods for overhead lines, 2016) that tension and sag are related to each other. When tension is increasing, sag is decreasing and vice versa.

The tension of cables is measured either using a direct measuring method with devices like load cells by imposing deflection and measuring restoring force or by strain measurements, or using indirect estimation methods that consider the cable's static sagging curve like tilt measurement, accurate spatial localization of one or multiple point along the sagging curve, or vibration characteristics analysis of conductor motion, like frequency analysis of measured motion of one or multiple point along the sagging curve thanks to accelerometers or IMU.

It is well-known from literature (see for example Cigre Group Task Force B2.12.3, brochure 324, Sag-Tension calculation methods for overhead lines, 2016) that the sagging curve y(x) of a conductor between two supports is given by the following catenary equation : $y \left(x\right) = \frac{H}{mg} \left[cos\left(\frac{mgx}{H}\right)-1\right] \approx \frac{{mgx}^{2}}{2 H}$ where *H*[N] is tension, *m*[kg/m] is the mass per unit length of the conductor, *g* (9.81 [m/s²]) is the gravity constant and *x*[m] is the abscissa along the horizontal distance between the supports and where the last expression on the right side of equation is the well-known parabola approximate. The slope $\frac{dy}{dx}$ of the sagging curve *y*(*x*) at a location *x*₀ can be measured by a tilt sensing device like an inclinometer or an accelerometer and is given by : $tilt = {\left.\frac{dy}{dx}\right|}_{x = {x}_{0}} \approx \frac{{mgx}_{0}}{H}$

Tension *H* is then directly related to tilt value measured at a given location by $H = \frac{{mgx}_{0}}{tilt}$. Then tension can be obtained from tilt. Tilt reading is available from the IMU used in the present invention.

From literature (see for example Cigre Group Task Force B2.12.3, brochure 324, Sag-Tension calculation methods for overhead lines, 2016) parabola approximate is a very good estimation of sag vs. tension relationship. This is given by sag = mgL²/8H, where H is tension, m is the mass per unit length, g is the gravity constant, and L the span length. Therefore, tension can be obtained from sag.

It is well-known from the literature that sag can be obtained from frequency analysis of the motion of the (see for example US patent No 8184015). This frequency analysis readings is available from the IMU used in the present invention.

Wave speed $c = \sqrt{\frac{H}{m}}$ is then directly related to a direct measured of tension or estimated through sag using parabola approximate as $c = \sqrt{\frac{H}{m}} = \sqrt{\frac{{gL}^{2}}{8 sag}}$. Tilt readings at sensor location *x*₀ can be obtained with using tilt measurement at sensor location as $c = \sqrt{\frac{H}{m}} = \sqrt{\frac{{gx}_{0}}{tilt}}$

## Claims

1. A method for estimating the severity of vibration, which is the product of vibration frequency f by antinode amplitude of vibration *A,* and for estimating fatigue lifetime or damage of a suspended electrical cable span of overhead power lines, said suspended electrical cable span having a sag possibly negligible with respect to span length, and a mean local tension *H,* and a local oscillating motion amplitude *u*(*x, t*) with a local space derivative of motion $\frac{\partial u}{\partial x}$, and being subject to a variation of said tension *H,* motion amplitude *u(x, t)* and said space derivative over time $\frac{\partial u}{\partial x}$*,* due to vibration, said method using an autonomous device respectively comprising a tension measuring device, a motion amplitude measuring device and a space derivative measuring device mounted thereon and fixed to the suspended cable span, as well as an on-board or remotely connected data processing unit, said method comprising the steps of :
a. measuring the mean local tension H of the suspended span over a time range, with the tension measuring device, so as to obtain a time-dependent tension measurement signal,
b. measuring the local motion amplitude *u*(*x, t*) and the local space derivative of motion amplitude $\frac{\partial u}{\partial x}$ of the suspended span over a time range, with the motion amplitude and the space derivative measuring devices respectively, so as to obtain a time-dependent motion measurement signal, said antinode amplitude of vibration *A* being related to the respective measurements of local motion, in particular acceleration, and space derivative thereof ;
c. performing a frequency or time-frequency analysis of said time-dependent tension measurement signal, with the data processing unit ;
d. performing a frequency or time-frequency analysis of said time-dependent motion amplitude measurement signal, with the data processing unit ;
e. performing a frequency or time-frequency analysis of said time-dependent space derivative of the motion amplitude measurement signal, with the data processing unit ;
wherein said estimation of the severity of vibration *Af* is obtained from the measurements of said amplitude motion *u*(*x, t*) and said space derivative of the motion amplitude $\frac{\partial u}{\partial x}$ according to the formula : $\sqrt{{c}^{2} {\left(\frac{\partial u}{\partial x}\right)}^{2} + \frac{1}{{ω}^{2}} {\left(\frac{{\partial }^{2} u}{\partial {t}^{2}}\right)}^{2}} = 2 π \left(Af\right) {e}^{jωt}$
where *ω,* $c = \sqrt{\frac{H}{m}}$, *H, m,* $\frac{\partial u}{\partial x}$*,* and $\frac{{\partial }^{2} u}{\partial {t}^{2}}$*,* are respectively the pulsation of the oscillating motion, the wave speed, the mean local tension of the suspended cable span, the mass per unit length of the suspended cable span, the space derivative of said motion amplitude, and the acceleration of said motion amplitude ;
and wherein said fatigue lifetime or damage are obtained from a number of cycles estimated from said tension frequency analysis and a stress level is obtained from said motion amplitude and said space derivative of the motion amplitude.

2. The method according to claim 1, wherein said motion amplitude measuring device and said space derivative of the motion amplitude measuring device are operating within a passband extending between 0 Hz and 1000 Hz.

3. The method according of claim 1, wherein said wave speed $c = \sqrt{\frac{H}{m}}$, is obtained from mean local tension *H* itself estimated from sag / frequency analysis, or by the relation between sag and tension being approximately given by sag = mgL²/8H, where m is the mass per unit length, g is the gravity constant, and L the span length ;
said sag being obtained from frequency analysis of conductor span motion or by local measurement of sagging curve inclination being directly related to sag in a relation between tilt of sagging curve and sag, approximately being a linear function in case of valid parabola approximate or a more complex function in the general case.

4. The method according to claim 3, wherein the local tension is measured by imposing a deflection to the cable portion of the overhead power line going through the autonomous device, using a device like a load cell, and measuring restoring force or strain, or is estimated by vibration frequency analysis of conductor motion, tilt measurement or accurate spatial localization of one or multiple point along the sagging curve, using accelerometers or an IMU.

5. Method according to claim 1, wherein the estimation of the severity of vibration, defined as the product of said antinode amplitude by said frequency, is obtained from the combined measurements of the local motion acceleration $a = \frac{{\partial }^{2} u}{\partial {t}^{2}}$ using an accelerometer and the time integration of the time derivative of angle, $\frac{\partial u}{\partial x} = \int {\partial }_{t} \left(\frac{\partial u}{\partial x}\right) dt = \int {gy}_{x} dt$ using an IMU gyroscope according to the following formula : $\sqrt{{c}^{2} {\left[\int {gy}_{x} dt\right]}^{2} + \frac{1}{{ω}^{2}} {a}^{2}} = 2 π \left(Af\right) {e}^{jωt}$

6. The method according to claim 1, wherein the free-loop antinode amplitude A is obtained as the maximum of a reconstructed amplitude along said suspended span using time-dependent signals of motion amplitude and time integration of said space derivative of motion shape along the vibrating conductor, using the following equation for the spatial distribution of the wave : $u \left(x=x0+j\frac{c}{fe}, t=\frac{n}{fe}\left[s\right]\right) = {f}_{1 , x 0} \left(n+j\right) + {f}_{2 , x 0} \left(n-j\right)$ where *f*_{1*,x*0} and *f*_{2,*x*0} are respectively two travelling waves *f*₁, *f*₂ measured at location *x*₀*, fe* [Hz] is the sampling frequency of data and *n* the time index component of time-dependent signal value, index *j* [-] represents the time laps corresponding at a change of location along the string, with the following limit conditions ${x}_{0} - {j}_{min} \frac{c}{fe} = 0$ and ${x}_{0} + {j}_{max} \frac{c}{fe} = l$*,* the spatial resolution *dx* of the reconstruction of motion being depending on sampling frequency and wave speed and given by $dx = \frac{c}{fe}$*.*

7. A non-transitory computer-readable medium with instructions stored thereon, that when executed by a computer processor, performs the steps of the method according to claim 1, when the computer processor is on-board in the autonomous device or remotely connected to the autonomous device comprising the tension measuring device, the motion amplitude measuring device and the motion amplitude space derivative measuring device mounted thereon for respectively measuring the mean local tension, the local acceleration and the local motion space derivative of the suspended span over a time range.

8. A monitoring system for estimating the severity of vibration, which is the product of vibration frequency f by antinode amplitude of vibration A, and for estimating fatigue lifetime or damage of a suspended electrical cable span of overhead power lines, said system comprising :
- an autonomous device fixed on said suspended cable span, and comprising respective tension, motion amplitude and motion amplitude spatial derivative measuring devices mounted thereon ; and
- an on-board data processing unit or a data processing unit remotely connected to the autonomous device ;
and configured to implement at least part of the following steps :
- measuring the mean local tension H of the suspended span over a time range, with the tension measuring device, so as to obtain a time-dependent tension measurement signal, said antinode amplitude of vibration being related to the mean local tension measurement ;
- measuring the time-dependent local motion amplitude *u*(*x, t*) and local space derivative of motion amplitude $\frac{\partial u}{\partial x}$ of the suspended span over a time range, with the motion amplitude and the space derivative measuring devices respectively, so as to obtain a time-dependent motion measurement signal, said antinode amplitude of vibration *A* being related to the respective measurements of local motion and space derivative thereof ;
- performing a frequency or time-frequency analysis of said time-dependent tension measurement signal, with the data processing unit,
- performing a frequency or time-frequency analysis of said time-dependent motion amplitude measurement signal, with the data processing unit, and
- performing a frequency or time-frequency analysis of said time-dependent motion space derivative measurement signal, with the data processing unit ;
wherein said estimation of the severity of vibration *Af* is obtained from the measurements of said amplitude motion *u(x, t)* and said space derivative of the motion amplitude $\frac{\partial u}{\partial x}$ according to the formula : $\sqrt{{c}^{2} {\left(\frac{\partial u}{\partial x}\right)}^{2} + \frac{1}{{ω}^{2}} {\left(\frac{{\partial }^{2} u}{\partial {t}^{2}}\right)}^{2}} = 2 π \left(Af\right) {e}^{jωt}$
where *ω,* $c = \sqrt{\frac{H}{m}}$, *H, m,* $\frac{\partial u}{\partial x}$*,* and $\frac{{\partial }^{2} u}{\partial {t}^{2}}$, are respectively the pulsation of the oscillating motion, the wave speed, the mean local tension of the suspended cable span, the mass per unit length of the suspended cable span, the space derivative of said motion amplitude, and the acceleration of said motion amplitude ;
and wherein said fatigue lifetime or damage are obtained from a number of cycles estimated from said tension frequency analysis and a stress level is obtained from said motion amplitude and said space derivative of the motion amplitude.

9. The monitoring system according to claim 8, wherein the motion amplitude or acceleration measuring device consists in one or more accelerometers and the motion amplitude space derivative device consists in one or more gyroscopes.

10. The monitoring system according to claim 8, wherein the motion amplitude or acceleration measuring device and the motion amplitude space derivative device consists in an IMU or a combination of accelerometers and gyroscopes.

## Patentansprüche

1. Verfahren zum Schätzen der Schwere von Schwingungen, was das Produkt aus Schwingungsfrequenz f und Schwingungsbauchamplitude A ist, sowie zum Schätzen der Ermüdungslebensdauer oder des Schadens eines aufgehängten elektrischen Kabelabschnitts von Freileitungen, wobei der aufgehängte elektrische Kabelabschnitt einen Durchhang, der gegenüber der Spannlänge möglicherweise vernachlässigbar ist, und eine mittlere lokale Spannung *H* sowie eine lokale oszillierende Bewegungsamplitude *u(x, t)* mit einer lokalen räumlichen Ableitung der Bewegung $\frac{\partial u}{\partial x}$ aufweist, und einer zeitlichen Änderung der Spannung *H,* der Bewegungsamplitude *u(x, t)* und der räumlichen Ableitung $\frac{\partial u}{\partial x}$ infolge der Schwingung unterliegt, wobei das Verfahren eine autonome Vorrichtung verwendet, die jeweils eine Spannungsmessvorrichtung, eine Bewegungsamplitudenmessvorrichtung und eine Vorrichtung zum Messen der räumlichen Ableitung umfasst, die an dem aufgehängten Kabelabschnitt angebracht und dort befestigt sind, sowie eine an Bord befindliche oder ferngesteuerte Datenverarbeitungseinheit, wobei das Verfahren folgende Schritte umfasst:
a. Messen der mittleren lokalen Spannung H des aufgehängten Abschnitts über einen Zeitraum mit der Spannungsmessvorrichtung, um ein zeitabhängiges Spannungssignalmesssignal zu erlangen,
b. Messen der lokalen Bewegungsamplitude *u(x, t)* und der lokalen räumlichen Ableitung der Bewegungsamplitude $\frac{\partial u}{\partial x}$ des aufgehängten Abschnitts über einen Zeitraum mit den Bewegungsamplituden- bzw. Ableitungsmessvorrichtungen, um ein zeitabhängiges Bewegungssignalmesssignal zu erlangen, wobei die Schwingungsbauchamplitude A mit den jeweiligen Messungen der lokalen Bewegung, insbesondere der Beschleunigung, und deren räumlicher Ableitung in Beziehung steht;
c. Durchführen einer Frequenz- oder Zeit-Frequenz-Analyse des zeitabhängigen Spannungssignalmesssignals mit der Datenverarbeitungseinheit;
d. Durchführen einer Frequenz- oder Zeit-Frequenz-Analyse des zeitabhängigen Bewegungsamplitudenmesssignals mit der Datenverarbeitungseinheit;
e. Durchführen einer Frequenz- oder Zeit-Frequenz-Analyse des zeitabhängigen Messsignals der räumlichen Ableitung der Bewegungsamplitude mit der Datenverarbeitungseinheit;
wobei die Schätzung der Schwere der Schwingung *Af* aus den Messungen der genannten Bewegungsamplitude *u(x, t)* und der räumlichen Ableitung der Bewegungsamplitude $\frac{\partial u}{\partial x}$ gemäß folgender Formel erlangt wird: $\sqrt{{c}^{2} {\left(\frac{\partial u}{\partial x}\right)}^{2} + \frac{1}{{ω}^{2}} {\left(\frac{{\partial }^{2} u}{\partial {t}^{2}}\right)}^{2}} = 2 π \left(Af\right) {e}^{jωt}$
wobei *ω*, $c = \sqrt{\frac{H}{m}}$, *H, m,* $\frac{\partial u}{\partial x}$, und $\frac{{\partial }^{2} u}{\partial {t}^{2}} ,$ jeweils die Pulsation der oszillierenden Bewegung, die Wellengeschwindigkeit, die mittlere lokale Spannung des aufgehängten Kabelabschnitts, die Masse pro Längeneinheit des aufgehängten Kabelabschnitts, die räumliche Ableitung der Bewegungsamplitude und die Beschleunigung der Bewegungsamplitude sind;
und wobei die Ermüdungslebensdauer oder der Schaden anhand einer anhand der Spannungsfrequenzanalyse geschätzten Anzahl von Zyklen erlangt wird und ein Spannungsgrad anhand der Bewegungsamplitude und der räumlichen Ableitung der Bewegungsamplitude erhalten wird.

2. Verfahren nach Anspruch 1, wobei die Bewegungsamplitudenmessvorrichtung und die Vorrichtung zum Messen der räumlichen Ableitung der Bewegungsamplitude in einem Durchlassbereich zwischen 0 Hz und 1000 Hz betrieben werden.

3. Verfahren nach Anspruch 1, wobei die Wellengeschwindigkeit $c = \sqrt{\frac{H}{m}}$, anhand der mittleren lokalen Spannung *H* an sich geschätzt wird, die aus Durchhang-/Frequenzanalyse erlangt wird, oder durch die Beziehung zwischen Durchhang und Spannung, die näherungsweise durch Durchhang = m·g·L²/8H gegeben ist, wobei m die Masse pro Längeneinheit, g die Gravitationskonstante und L die Spannlänge ist;
wobei der Durchhang anhand der Frequenzanalyse der Leiterbewegung oder durch lokale Messung der Neigung der Durchhangkurve erlangt wird, die direkt mit dem Durchhang in einer Beziehung zwischen Neigung der Durchhangkurve und Durchhang verknüpft ist, wobei diese Beziehung im Fall einer gültigen Parabelnäherung näherungsweise linear oder im allgemeinen Fall komplexer ist.

4. Verfahren nach Anspruch 3, wobei die lokale Spannung gemessen wird, indem eine Ablenkung an dem Kabelabschnitt der Freileitung, der durch die autonome Vorrichtung verläuft, unter Verwendung einer Vorrichtung, wie beispielsweise einer Wägezelle erzwungen und die Rückstellkraft oder Dehnung gemessen wird, oder durch Schwingungsfrequenzanalyse der Leiterbewegung, Neigungsmessung oder genaue räumliche Lokalisierung eines oder mehrerer Punkte entlang der Durchhangkurve unter Verwendung von Beschleunigungssensoren oder einer IMU geschätzt wird.

5. Verfahren nach Anspruch 1, wobei die Schätzung der Schwere der Schwingung, definiert als das Produkt der Schwingungsbauchamplitude mit der Frequenz, aus den kombinierten Messungen der lokalen Bewegungsbeschleunigung $a = \frac{{\partial }^{2} u}{\partial {t}^{2}}$ unter Verwendung eines Beschleunigungssensors und der Zeitintegration der zeitlichen Ableitung des Winkels, $\frac{\partial u}{\partial x} = \int {\partial }_{t} \left(\frac{\partial u}{\partial x}\right) dt = \int {gy}_{x} dt$ unter Verwendung eines IMU-Gyroskops gemäß folgender Formel erlangt wird: $\sqrt{{c}^{2} {\left[\int {gy}_{x} dt\right]}^{2} + \frac{1}{{ω}^{2}} {a}^{2}} = 2 π \left(Af\right) {e}^{jωt}$

6. Verfahren nach Anspruch 1, wobei die freie Schwingungsbauchamplitude A als das Maximum einer rekonstruierten Amplitude entlang des genannten aufgehängten Abschnitts unter Verwendung zeitabhängiger Signale der Bewegungsamplitude und der Zeitintegration der räumlichen Ableitung der Bewegungsform entlang des schwingenden Leiters erlangt wird, wobei folgende Gleichung für die räumliche Verteilung der Welle verwendet wird: $u \left(x=x0+j\frac{c}{fe}, t=\frac{n}{fe}\left[s\right]\right) = {f}_{1 , x 0} \left(n+j\right) + {f}_{2 , x 0} \left(n-j\right)$ wobei *f_{1,x0}* und *f_{2,x0}* jeweils zwei laufende Wellen *f*₁, *f*₂ sind, die an der Position x₀ gemessen werden, fₑ [Hz] die Abtastfrequenz der Daten ist und *n* die Zeitindexkomponente des zeitabhängigen Signalwerts ist, Index *j* [-] das Zeitintervall darstellt, das einer Ortsänderung entlang der Saite entspricht, mit folgenden Randbedingungen ${x}_{0} - {j}_{min} \frac{c}{fe} = 0$ und ${x}_{0} + {j}_{max} \frac{c}{fe} = I ,$, wobei die räumliche Auflösung *dx* der Rekonstruktion der Bewegung von der Abtastfrequenz und der Wellengeschwindigkeit abhängt und durch $dx = \frac{c}{fe}$ gegeben ist.

7. Nicht-transitorisches, computerlesbares Medium mit darauf gespeicherten Anweisungen, die, wenn sie von einem Computerprozessor ausgeführt werden, die Schritte des Verfahrens nach Anspruch 1 ausführen, wenn der Computerprozessor sich an Bord der autonomen Vorrichtung ist oder entfernt mit der autonomen Vorrichtung verbunden ist, umfassend die darauf montierte Spannungsmessvorrichtung, Bewegungsamplitudenmessvorrichtung und Messvorrichtung der räumlichen Ableitung der Bewegungsamplitude zum jeweiligen Messen der mittleren lokalen Spannung, der lokalen Beschleunigung und der Ableitung des lokalen Bewegungsraums der aufgehängten Kabelspannweite über einen Zeitraum.

8. Überwachungssystem zum Schätzen der Schwere der Schwingung, welche das Produkt aus Schwingungsfrequenz f und Schwingungsbauchamplitude A ist, und zum Schätzen der Ermüdungslebensdauer oder des Schadens einer aufgehängten elektrischen Kabelspannweite von Freileitungen, das System umfassend:
- eine autonome Vorrichtung, die an der aufgehängten Kabelspannweite befestigt ist und umfassend jeweils darauf montierte Vorrichtungen zum Messen von Spannung, Bewegungsamplitude und räumlicher Ableitung der Bewegungsamplitude; und
- eine an Bord befindliche Datenverarbeitungseinheit oder eine mit der autonomen Vorrichtung entfernt verbundene Datenverarbeitungseinheit;
und das konfiguriert ist, um zumindest einen Teil der folgenden Schritte zu implementieren:
- Messen der mittleren lokalen Spannung H der aufgehängten Kabelspannweite über einen Zeitraum mit der Spannungsmessvorrichtung, um ein zeitabhängiges Spannungssignalmesssignal zu erlangen, wobei die Schwingungsbauchamplitude mit der mittleren lokalen Spannungsmessung in Beziehung steht;
- Messen der zeitabhängigen lokalen Bewegungsamplitude *u(x, t)* und der lokalen räumlichen Ableitung der Bewegungsamplitude $\frac{\partial u}{\partial x}$ der aufgehängten Kabelspannweite über einen Zeitraum mit den Bewegungsamplituden- und den räumlichen Ableitungsmessvorrichtungen, um jeweils ein zeitabhängiges Bewegungssignalmesssignal zu erlangen, wobei die Schwingungsbauchamplitude *A* mit den jeweiligen Messungen der lokalen Bewegung und deren räumlicher Ableitung in Beziehung steht;
- Durchführen einer Frequenz- oder Zeit-Frequenz-Analyse des zeitabhängigen Spannungssignalmesssignals mit der Datenverarbeitungseinheit,
- Durchführen einer Frequenz- oder Zeit-Frequenz-Analyse des zeitabhängigen Bewegungsamplitudenmesssignals mit der Datenverarbeitungseinheit, und
- Durchführen einer Frequenz- oder Zeit-Frequenz-Analyse des zeitabhängigen Messsignals der räumlichen Bewegungsableitung mit der Datenverarbeitungseinheit;
wobei die Schätzung der Schwere der Schwingung *Af* anhand der Messungen der Bewegungsamplitude *u(x, t)* und der räumlichen Ableitung der Bewegungsamplitude $\frac{\partial u}{\partial x}$ gemäß folgender Formel erlangt wird: $\sqrt{{c}^{2} {\left(\frac{\partial u}{\partial x}\right)}^{2} + \frac{1}{{ω}^{2}} {\left(\frac{{\partial }^{2} u}{\partial {t}^{2}}\right)}^{2}} = 2 π \left(Af\right) {e}^{jωt}$
wobei *ω,* $c = \sqrt{\frac{H}{m}}$*, H, m,* $\frac{\partial u}{\partial x}$*,* und $\frac{{\partial }^{2} u}{\partial {t}^{2}}$, die Kreisfrequenz der Schwingungsbewegung, Af das Produkt aus Schwingungsfrequenz und Schwingungsbauchamplitude, H die mittlere lokale Spannung der aufgehängten Kabelspannweite, µ die Masse pro Längeneinheit der aufgehängten Kabelspannweite, die räumliche Ableitung der Bewegungsamplitude und die Beschleunigung der Bewegungsamplitude ist;
und wobei die Ermüdungslebensdauer oder der Schaden aus einer Anzahl von Zyklen, die anhand der Spannungsfrequenzanalyse geschätzt werden, erlangt wird und ein Spannungsgrad anhand der Bewegungsamplitude und der räumlichen Ableitung der Bewegungsamplitude erlangt wird.

9. Überwachungssystem nach Anspruch 8, wobei die Bewegungsamplituden- oder Beschleunigungsmessvorrichtung aus einem oder mehreren Beschleunigungssensoren besteht und die Vorrichtung zum Messen der räumlichen Ableitung der Bewegungsamplitude aus einem oder mehreren Gyroskopen besteht.

10. Überwachungssystem nach Anspruch 8, wobei die Bewegungsamplituden- oder Beschleunigungsmessvorrichtung und die Vorrichtung zum Messen der räumlichen Ableitung der Bewegungsamplitude aus einer IMU oder einer Kombination aus Beschleunigungssensoren und Gyroskopen bestehen.

## Revendications

1. Procédé pour estimer l'intensité d'une vibration, qui est le produit de la fréquence de vibration f par l'amplitude d'antinode de vibration *A*, et la durée de vie en fatigue ou dommages d'une portée de câble électrique suspendu de lignes électriques aériennes, ladite portée de câble électrique suspendu présentant un affaissement éventuellement négligeable par rapport à la longueur de la portée, ainsi qu'une tension locale moyenne *H* et une amplitude de mouvement oscillatoire locale *u(x,t)* avec une dérivée spatiale locale du mouvement $\frac{\partial u}{\partial x}$, et étant soumise à une variation de ladite tension *H*, de l'amplitude de mouvement *u(x,t)* et de ladite dérivée spatiale dans le temps $\frac{\partial u}{\partial x}$, due aux vibrations, ledit procédé utilisant un dispositif autonome comprenant respectivement un dispositif pour mesurer la tension, un dispositif pour mesurer l'amplitude de mouvement et un dispositif pour mesurer la dérivée spatiale montés sur celui-ci et fixé à la portée de câble suspendu, ainsi qu'une unité de traitement de données embarquée ou connectée à distance, ledit procédé comprenant les étapes suivantes :
a) mesurer la tension locale moyenne H de la portée suspendue sur un intervalle de temps, à l'aide du dispositif pour mesurer la tension, de manière à obtenir un signal de mesure de tension lié au temps,
b) mesurer l'amplitude locale de mouvement *u(x,t)* et la dérivée spatiale locale de l'amplitude de mouvement $\frac{\partial u}{\partial x}$ de la portée suspendue sur un intervalle de temps, à l'aide des dispositifs pour mesurer respectivement l'amplitude de mouvement et la dérivée spatiale, de manière à obtenir un signal de mesure de mouvement lié au temps, ladite amplitude d'antinode de vibration *A* étant liée aux mesures respectives du mouvement local, en particulier de l'accélération, et de sa dérivée spatiale ;
c) analyser la fréquence ou temps-fréquence dudit signal de mesure de tension lié au temps, à l'aide de l'unité de traitement de données ;
d) analyser la fréquence ou temps-fréquence dudit signal de mesure d'amplitude de mouvement lié du temps, à l'aide de l'unité de traitement de données ;
e) analyser la fréquence ou temps-fréquence de ladite dérivée spatiale liée au temps du signal de mesure de l'amplitude de mouvement, à l'aide de l'unité de traitement de données ;
**caractérisé en ce que** ladite estimation de l'intensité de vibration *Af* est obtenue à partir des mesures de ladite amplitude de mouvement *u(x,t)* et de ladite dérivée spatiale de l'amplitude de mouvement $\frac{\partial u}{\partial x}$ selon la formule : $\sqrt{{c}^{2} {\left(\frac{\partial u}{\partial x}\right)}^{2} + \frac{1}{{ω}^{2}} {\left(\frac{{\partial }^{2} u}{\partial {t}^{2}}\right)}^{2}} = 2 π \left(Af\right) {e}^{jωt}$
où ω, $c = \sqrt{\frac{H}{m}}$, m, $\frac{\partial u}{\partial x}$ et $\frac{{\partial }^{2} u}{\partial {t}^{2}}$ sont respectivement la pulsation du mouvement oscillatoire, la vitesse d'onde, la tension locale moyenne de la portée de câble suspendu, la masse par unité de longueur de la portée de câble suspendu, la dérivée spatiale de ladite amplitude de mouvement et l'accélération de ladite amplitude de mouvement ;
et **caractérisé en ce que** ladite durée de vie en fatigue ou les dommages sont obtenus à partir d'un nombre de cycles estimé à partir de ladite analyse de fréquence de tension, et un niveau de contrainte est obtenu à partir de ladite amplitude de mouvement et de ladite dérivée spatiale de l'amplitude de mouvement.

2. Procédé selon la revendication 1, **caractérisé en ce que** ledit dispositif pour mesurer l'amplitude de mouvement et ledit dispositif pour mesurer la dérivée spatiale de l'amplitude de mouvement fonctionnent dans une bande passante s'étendant entre 0 Hz et 1 000 Hz.

3. Procédé selon la revendication 1, **caractérisé en ce que** ladite vitesse d'onde $c = \sqrt{\frac{H}{m}}$ est obtenue à partir de la tension locale moyenne *H* elle-même estimée à partir de l'analyse de l'affaissement/ fréquence, ou par la relation entre l'affaissement et la tension étant donnée approximativement par affaissement = mgL²/8H, où m est la masse par unité de longueur, g est la constante de gravité, et L la longueur de portée ;
ledit affaissement étant obtenu à partir de l'analyse fréquentielle du mouvement de la portée du conducteur ou par la mesure locale de l'inclinaison de la courbe d'affaissement, qui est directement liée à l'affaissement selon une relation entre l'inclinaison de la courbe d'affaissement et l'affaissement, cette relation étant approximativement une fonction linéaire dans le cas d'une approximation parabolique valable ou une fonction plus complexe dans le cas général.

4. Procédé selon la revendication 3, **caractérisé en ce que** la tension locale est mesurée en imposant une déviation à la partie de câble de la ligne électrique aérienne passant par le dispositif autonome, à l'aide d'un dispositif tel qu'une cellule de charge, et en mesurant la force de rappel ou la déformation, ou est estimée en analysant la fréquence de vibration du mouvement du conducteur, par mesure de l'inclinaison ou par localisation spatiale précise d'un ou plusieurs points le long de la courbe d'affaissement, à l'aide d'accéléromètres ou d'une IMU.

5. Procédé selon la revendication 1, **caractérisé en ce que** l'estimation de l'intensité de vibration, définie comme le produit de ladite amplitude d'antinode par ladite fréquence, est obtenue à partir des mesures combinées de l'accélération du mouvement local $a = \frac{{\partial }^{2} u}{\partial {t}^{2}}$ à l'aide d'un accéléromètre et de l'intégration du temps de la dérivée au temps de l'angle, $\frac{\partial u}{\partial x} = \int {\partial }_{t} \left(\frac{\partial u}{\partial x}\right) dt = \int {gy}_{x} dt$ à l'aide d'un gyroscope IMU selon la formule suivante : $\sqrt{{c}^{2} {\left[\int {gy}_{x} dt\right]}^{2} + \frac{1}{{ω}^{2}} {a}^{2}} = 2 π \left(Af\right) {e}^{jωt}$

6. Procédé selon la revendication 1, **caractérisé en ce que** l'amplitude d'antinode *A* en boucle libre est obtenue comme le maximum d'une amplitude reconstruite le long de ladite portée suspendue à l'aide de signaux liés au temps représentant l'amplitude du mouvement et de l'intégration dans le temps de ladite dérivée spatiale de la forme du mouvement le long du conducteur en vibration, en utilisant l'équation suivante pour la distribution spatiale de l'onde : $u \left(x=x0+j\frac{c}{fe}, t=\frac{n}{fe}\left[s\right]\right) = {f}_{1 , x 0} \left(n+j\right) + {f}_{2 , x 0} \left(n-j\right)$ où *f*_{1,*x*0} et *f*_{2,*x*0} sont respectivement deux ondes progressives *f*₁, *f*₂ mesurées à l'emplacement *x*₀*, fe* [Hz] est la fréquence d'échantillonnage des données et *n* la composante d'indice temporel de la valeur du signal lié au temps, l'indice *j* [-] représente les intervalles de temps correspondant à un changement d'emplacement le long de la corde, avec les conditions limites suivantes : ${x}_{0} - {j}_{min} \frac{c}{fe} = 0$ et ${x}_{0} + {j}_{max} \frac{c}{fe} = l$, la résolution spatiale *dx* de la reconstruction du mouvement dépendant de la fréquence d'échantillonnage et de la vitesse de l'onde et étant donnée par $dx = \frac{c}{fe}$*.*

7. Support non éphémère informatisé sur lequel sont stockées des instructions qui, lorsqu'elles sont exécutées par un processeur informatique, mettent en œuvre les étapes du procédé selon la revendication 1, lorsque le processeur informatique est embarqué au dispositif autonome ou connecté à distance au dispositif autonome, lequel comprend le dispositif pour mesurer la tension, le dispositif pour mesurer l'amplitude de mouvement et le dispositif pour mesurer la dérivée spatiale de l'amplitude de mouvement montés sur celui-ci pour mesurer respectivement la tension locale moyenne, l'accélération locale et la dérivée spatiale du mouvement local de la portée suspendue sur un intervalle de temps.

8. Système de surveillance pour estimer l'intensité de vibration, qui est le produit de la fréquence de vibration f par l'amplitude d'antinode de vibration A, et pour estimer la durée de vie en fatigue ou les dommages d'une portée de câble électrique suspendu de lignes électriques aériennes, ledit système comprenant :
- un dispositif autonome fixé sur ladite portée de câble suspendu, et comprenant des dispositifs respectifs pour mesurer la tension, l'amplitude de mouvement et la dérivée spatiale de l'amplitude de mouvement montés sur celui-ci ; et
- une unité de traitement de données embarquée ou une unité de traitement de données connectée à distance au dispositif autonome ;
et configuré pour mettre en œuvre au moins une partie des étapes suivantes :
- mesurer la tension locale moyenne H de la portée suspendue sur un intervalle de temps, à l'aide du dispositif pour mesurer la tension, de manière à obtenir un signal de mesure de tension lié au temps, ladite amplitude d'antinode de vibration étant liée à la mesure de tension locale moyenne ;
- mesurer l'amplitude locale de mouvement *u(x,t)* liée au temps et la dérivée spatiale locale de l'amplitude de mouvement $\frac{\partial u}{\partial x}$ de la portée suspendue sur un intervalle de temps, à l'aide des dispositifs pour mesurer respectivement l'amplitude de mouvement et la dérivée spatiale, de manière à obtenir un signal de mesure de mouvement lié au temps, ladite amplitude d'antinode de vibration A étant liée aux mesures respectives du mouvement local et de sa dérivée spatiale ;
- analyser la fréquence ou temps-fréquence dudit signal de mesure de tension lié au temps, à l'aide de l'unité de traitement de données,
- analyser la fréquence ou temps-fréquence dudit signal de mesure de l'amplitude de mouvement lié au temps, à l'aide de l'unité de traitement de données, et
- analyser la fréquence ou temps-fréquence dudit signal de mesure de la dérivée spatiale du mouvement lié au temps, à l'aide de l'unité de traitement de données ;
**caractérisé en ce que** ladite estimation de l'intensité de vibration *Af* est obtenue à partir des mesures dudit mouvement d'amplitude *u(x,t)* et de ladite dérivée spatiale de l'amplitude de mouvement $\frac{\partial u}{\partial x}$ selon la formule : $\sqrt{{c}^{2} {\left(\frac{\partial u}{\partial x}\right)}^{2} + \frac{1}{{ω}^{2}} {\left(\frac{{\partial }^{2} u}{\partial {t}^{2}}\right)}^{2}} = 2 π \left(Af\right) {e}^{jωt}$
où w, $c = \sqrt{\frac{H}{m}}$, *H, m,* $\frac{\partial u}{\partial x}$ et $\frac{{\partial }^{2} u}{\partial {t}^{2}}$, sont respectivement la pulsation du mouvement oscillatoire, la vitesse d'onde, la tension locale moyenne de la portée de câble suspendu, la masse par unité de longueur de la portée de câble suspendu, la dérivée spatiale de ladite amplitude de mouvement et l'accélération de ladite amplitude de mouvement ;
et **caractérisé en ce que** ladite durée de vie en fatigue ou les dommages sont obtenus à partir d'un nombre de cycles estimé à partir de ladite analyse de fréquence de tension, et un niveau de contrainte est obtenu à partir de ladite amplitude de mouvement et de ladite dérivée spatiale de l'amplitude de mouvement.

9. Système de surveillance selon la revendication 8, **caractérisé en ce que** le dispositif pour mesurer l'accélération ou l'amplitude de mouvement consiste en un ou plusieurs accéléromètres et le dispositif pour mesurer la dérivée spatiale de l'amplitude de mouvement consiste en un ou plusieurs gyroscopes.

10. Système de surveillance selon la revendication 8, **caractérisé en ce que** le dispositif pour mesurer l'accélération ou l'amplitude de mouvement et le dispositif pour mesurer la dérivée spatiale de l'amplitude de mouvement consistent en une IMU ou en une combinaison d'accéléromètres et de gyroscopes.
